Europäisches Patentamt

European Patent Office

Office européen des brevets

(11) Numéro de publication: **0 228 956**
**A1**

(12) # DEMANDE DE BREVET EUROPEEN

(21) Numéro de dépôt: 86402822.0

(22) Date de dépôt: 16.12.86

(51) Int. Cl.4: **H 01 L 29/36**
**H 01 L 29/80**

(30) Priorité: 20.12.85 FR 8518985

(43) Date de publication de la demande:
15.07.87 Bulletin 87/29

(84) Etats contractants désignés: **DE GB NL**

(71) Demandeur: **THOMSON-CSF**
**173, Boulevard Haussmann**
**F-75379 Paris Cedex 08 (FR)**

(72) Inventeur: **Pavlidis, Dimitrios**
**THOMSON-CSF SCPI 19, avenue de Messine**
**F-75008 Paris (FR)**

**Karapiperis, Léonidas**
**THOMSON-CSF SCPI 19, avenue de Messine**
**F-75008 Paris (FR)**

(74) Mandataire: **Taboureau, James et al**
**THOMSON-CSF SCPI 19, avenue de Messine**
**F-75008 Paris (FR)**

(54) **Transistor hyperfréquence de puissance.**

(57) L'invention concerne un transitor hyperfréquence de puissance.

Le transistor selon l'invention comporte, outre un substrat (11) et trois électrodes de grille, source et drain (13, 14, 15), au moins une couche active (12) et deux régions (16, 17) de prises de contacts. Pour éviter la formation d'un champ électrique de forte densité aux jonctions entre la couche active (12) de type n, et les régions (16, 17) de type n+, le matériau de transition (18, 19) entre couche active (12) et régions (16, 17) est dopé avec transition progressive continue, depuis le type n à proximité (20, 22) de la couche active (12) jusqu'au type n+ à proximité (21, 23) des régions (16, 17) de prises de contacts. Le dopage progressif se fait par implantation à faisceaux d'ions focalisés.

Application aux circuits intégrés hyperfréquence de puissance.

FIG_4

Bundesdruckerei Berlin

**Description**

TRANSISTOR HYPERFREQUENCE DE PUISSANCE

La présente invention concerne la structure d'un transistor à effet de champ de puissance, dans un circuit intégré hyperfréquence, ainsi que le procédé de réalisation d'un tel transistor dans des circuits intégrés de puissance. La structure selon l'invention évite la création de champs électriques localisés dans les transistors, et améliore les performances des circuits intégrés hyperfréquences de puissance.

Les circuits intégrés hyperfréquences comportent des transistors dont les couches actives sont de type n, de préférence aux couches actives de type p, en raison de la vitesse qui est demandée à ces transistors, parce que les électrons se déplacent plus vite que les trous dans les couches actives. Mais les métallisations de prise de contact de source et de drain sont déposées sur des couches dopées de type n+ parce que l'adhérence du métal y est meilleure que sur une couche de type n. Cependant le rendement électrique ainsi que la tension de claquage des circuits intégrés de puissance dépendent, parmi d'autres paramètres, de l'interface entre la couche active de type n du transistor et la couche de type n+ des régions d'accès, ou du profil de tranchée si le transistor comporte une tranchée sous la métallisation de grille. Une transition abrupte entre les couches n-n+ peut produire une faible tension de claquage et induire un mauvais rendement électrique dû à un champ électrique localisé de forte densité.

Il convient donc d'éviter la création de champs électriques localisés de forte densité et d'améliorer les performances des circuits intégrés de puissance par un procédé qui soit compatible avec les procédures technologiques des circuits intégrés.

C'est un premier objet de l'invention que de proposer une structure dans laquelle les transitions entre couche n et couche ou caisson n+ sont progressives dans la direction de propagation des porteurs de charge des transistors, ce profil progressif étant obtenu par une variation du niveau de dopage.

C'est également un objet de l'invention que de réaliser des transitions progressives entre les couches n et n+ en utilisant des faisceaux d'ions focalisés, car cette approche permet l'implantation d'ions d'énergie et à doses différentes sur des tranches du semiconducteur extrêmement fines. Ce procédé est compatible avec la technologie courante des circuits intégrés hyperfréquences, et il permet en une seule étape de réaliser la couche active et d'optimiser le composant de puissance, en donnant des résultats supérieurs à tous procédés chimiques puisque les profils de dopage générés ne dépendent pas du substrat, ou de la position de la plaque ni de masques pour le dopage graduel. Ce procédé permet donc d'améliorer la performance en puissance en garantissant une très bonne uniformité sur la plaque, condition nécessaire pour la réalisation industrielle de circuits intégrés hyperfréquences.

De façon plus précise l'invention concerne une structure de transistor à effet de champ, comportant, supporté par un substrat, au moins une couche active, en matériau semiconducteur de type n, sous l'électrode de grille, et une couche en matériau dopé de type n+, formant deux régions de prises de contacts sous les électrodes de source et drain, ce transistor étant caractérisé en ce que, en vue d'éviter un champ électrique de forte densité aux jonctions entre la couche active, dopée n, et les régions de prises de contacts, dopées n+, le matériau de transition compris entre ladite couche active et lesdites régions est dopé avec transition progressive du type n vers le type n+, la transition progressive étant orientée selon la direction de propagation des porteurs de charges électriques, depuis la grille vers la source et depuis la grille vers le drain.

L'invention sera mieux comprise par la description qui suit de deux exemples de réalisation de transistor de puissance dans des circuits intégrés hyperfréquences, cette description s'appuyant sur les figures jointes en annexe qui sont toutes des coupes, localisées dans la région du canal d'un transistor à effet de champ, et qui représentent :

- Figure 1 : transistor à effet de champ selon l'art connu, de structure plane, comportant une couche active n et deux caissons n+ de prise de contact avec les métallisations de source et de drain,

- Figure 2 : transistor à effet de champ selon l'art connu, comportant une tranchée sous la métallisation de grille,

- Figure 3 : transistor à effet de champ selon l'art connu comportant une gravure chimique d'au moins une couche n+ sous une métallisation de contact,

- Figure 4 : transistor à effet de champ selon l'invention, de structure plane, et comportant deux caissons n+ de prise de contact de source et de drain,

- Figure 5 : transistor à effet de champ selon l'invention, de structure à tranchée sous la grille, et comportant deux couches n+ de prise de contact de source et de drain.

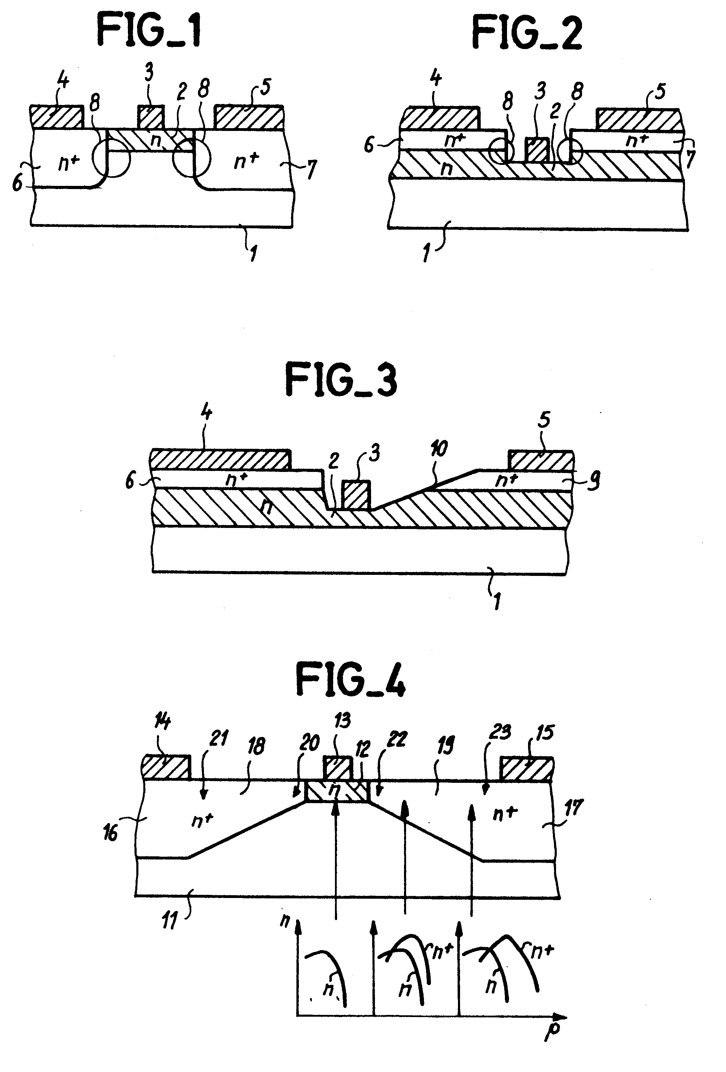

De façon très schématique, la région du canal dans un transistor à effet de champ selon l'art connu est représentée en figure 1. Un substrat 1, en matériau semi-isolant par exemple, supporte au moins une couche active 2, en matériau dopé de type n : sur cette couche active 2 est déposée la métallisation de grille 3. Les métallisations de source et de drain, 4 et 5, sont déposées sur deux caissons implantés 6 et 7, respectivement, de type n+ : ces deux caissons ont la double fonction d'assurer une meilleure adhérence du métal des métallisations de source et de drain sur le matériau semiconducteur d'une part, et d'autre part de diminuer les résistances d'accès entre la source et le drain, 4 et 5, et la couche active ou canal 2. Les deux caissons n+ 6 et 7 sont réalisés par une implantation ionique de silicium ou de germanium par exemple si le transistor à effet de champ est en GaAs, l'implantation étant à faible dose et forte énergie, ou forte dose et faible énergie. Selon les conditions d'implantation utilisées, la distribution gaussienne des ions implantés produit une zone de transition, entre la couche active 2 et l'un des caissons 6 ou 7, qui dépasse rarement 500 angströms de longueur. Une transition entre couches n et n+ peut donner lieu à la génération d'un champ électrique localisé, avec tous les désavantages associés. C'est aux interfaces 8 entre couches n et n+ que se développent ces champs électriques localisés.

La figure 2 représente la coupe localisée dans la région du canal d'un transistor à effet de champ selon l'art connu, dans lequel la différence par rapport au transistor de figure 1 est qu'une tranchée, plus communément appelée "recess" est creusée sous la métallisation de grille 3. Ce procédé a l'avantage d'éviter l'implantation localisée de deux caissons n et n+, mais le phénomène de champ électrique développé à l'interface 8 entre les couches n et n+ demeure.

Une transition abrupte de dopage entre deux couches n et n+ peut produire une accumulation de charges de manière équivalente à l'effet Gunn. Un fort champ localisé est ainsi formé entre la grille et le drain du transistor, donnant lieu à une augmentation de la résistance parasite série, et par conséquent à une dégradation des caractéristiques du transistor de puissance. Il est expérimentalement constaté que la tension de claquage des transistors à transition abrupte est relativement faible et ne convient pas aux circuits intégrés de puissance. La présence d'un fort champ localisé est manifestée par l'émission de lumière due à une injection de trous dans le sens drain/grille, et par l'augmentation de la tension de claquage quand on augmente la tension négative appliquée sur la grille, avec diminution de courant drain.

Bien entendu, ce qui est valable au sujet du drain est également valable au sujet de la source, mais il est bien connu que dans un transistor à effet de champ les effets parasites se développent entre la grille et le drain d'avantage qu'entre la grille et la source.

Pour résoudre ce problème de trop faible tension de claquage et de mauvaises performances de puissance d'un transistor, il faut donc remplacer les transitions abruptes entre couches n et n+ par des transitions progressives.

Une première structure connue consiste à remplacer une couche ou un caisson, tel que 6 ou 7, par deux couches ou deux caissons, qui sont obtenus par une double implantation ou une double diffusion. Ce procédé donne donc une structure dans laquelle les couches ou caissons n+ présentent deux marches, mais il n'est pas connu de structures dans lesquelles il y ait plus que deux marches, puisque ce procédé nécessite un masquage.

Une autre approche consiste à réaliser un recess graduel entre la grille et le drain : c'est cette structure qui est représentée en figure 3.

Le transistor de puissance de la figure 3, pour lequel on a conservé les mêmes indices de repère que sur les deux figures précédentes, comporte une couche n+ 9, qui supporte la métallisation 5 de drain. Cette couche 9, ainsi qu'une partie de la couche active 2, présente une structure qui s'épaissit progressivement depuis la couche active 2 sous la métallisation de grille 3 vers la métallisation de drain 5, présentant ainsi une face 10 qui est inclinée et réduit progressivement le champ électrique aux environs de la jonction entre couche n 2 et couche n+ 9. Cette approche dépend de l'orientation du substrat par rapport à la grille du transistor, de la solution chimique de gravure, du temps d'attaque, et d'autres considérations encore. Elle n'est par conséquent pas adaptable aux technologies intégrées qui nécessitent des procédures reproductibles de grande uniformité.

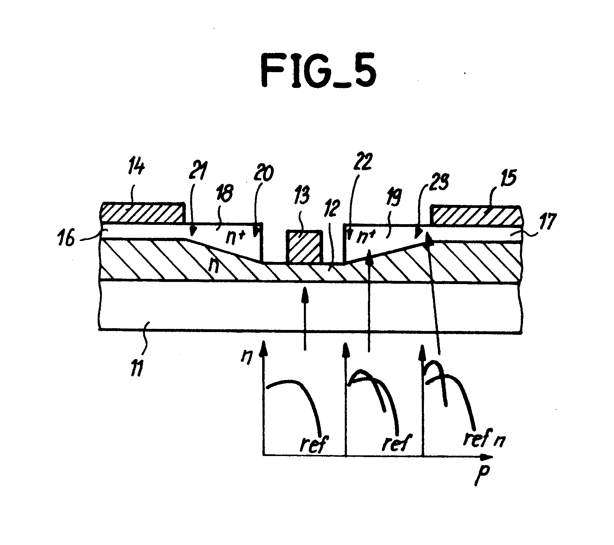

Ce n'est pas le cas de la structure et du procédé selon l'invention, qui permet de réaliser des transitions progressives entre les couches n et n+ telles que représentées sur les figures 4 et 5.

La figure 4 représente donc une première forme du transistor de puissance hyperfréquence selon l'invention, dans une structure plane, correspondant à deux caissons de type n+ de prise de contact ohmique avec les métallisations de source et de drain. Cette figure a été très dilatée selon un axe horizontal de façon à faciliter la représentation de la région de transition progressive.

Ce transistor selon l'invention comporte donc un substrat 11, en matériau semi-isolant par exemple, qui supporte au moins une couche active 12 de type n, et une métallisation de grille 13 sur la couche active 12. Les métallisations 14 et 15 de source et de drain sont supportées respectivement par deux caissons n+ 16 et 17. La structure, ou la géométrie, qui fait la particularité de ce transistor consiste en ce que l'épaisseur du matériau de transition, entre la couche active et les caissons varie progressivement depuis l'épaisseur du matériau dopé n dans la couche active 12, jusqu'à l'épaisseur de matériau dopé n+ dans les caissons 16 et 17. Ces deux transitions progressives, dans les régions 18 et 19, présentent donc une structure dans laquelle l'interface entre les couches n+ et le substrat ne sont pas planes et parallèles à la surface de la pastille, mais sont en plan incliné par rapport à cette même surface, l'épaisseur des régions 18 et 19 étant minimale dans les zones 20 et 22 proches de la couche active 12, et maximale dans les zones 21 et 23 proches des caissons 16 et 17. Bien entendu, deux régions de transitions progressives 18 et 19 ont été représentées sur la figure 4, mais, de même qu'en figure 3 un seul "recess" progressif était représenté, il appartient au domaine de l'invention qu'une seule transition progressive entre grille et drain par exemple soit réalisée.

La transition progressive, dans les régions 18 et 19, entre les niveaux de dopage n en 12 et n+ en 16 et 17 est obtenue par implantation sans masquage et le plan incliné peut être défini avec une précision supérieure à 1000 angströms, ce qui est impossible avec les techniques utilisant des masques de diffusion ou d'implantation.

En effet, les transitions progressives entre la couche active 12 et les caissons 16 et 17 sont obtenues par implantation à faisceaux d'ions focalisés, sans masque, sur des bandes parallèles entre elles, et larges de 0,1 à 0, 2 microns, avec augmentation progressive de la dose d'implantation et de l'énergie depuis la grille vers le drain et depuis la grille vers la source. Par bandes parallèles, il faut entendre que les bandes implantées par un faisceau d'ions focalisés sont parallèles aux métallisations de source, de grille et de drain, c'est-à-dire perpendiculaires au plan de la figure, selon la représentation habituelle d'un transistor à effet de champ. Ces transitions progressives, à la fois dans l'épaisseur des couches et dans le niveau des dopages, permettent d'éviter l'interface abrupte entre des couches n et n+, et par conséquent un fort champ électrique, dû à la mobilité différentielle négative dans l'aséniure de gallium.

Sur la figure 4 sont représentés trois graphiques donnant le niveau de dopage en fonction de la profondeur dans la couche considérée. Le premier graphique, à gauche, donne le niveau de dopage de la couche active 12 de type n. Le second graphique, au centre, donne le niveau de dopage de la région de transition progressive 19, dans la zone 22 proche de la couche active 12 : à la courbe de dopage du matériau n qui existait à l'origine s'ajoute une courbe de dopage en 22 à plus fortes énergie et dose. Le troisième graphique, à droite, donne le niveau de dopage dans la zone 23 : à la courbe de dopage du matériau n de départ s'ajoute la courbe de dopage à très fortes énergie et dose dans la zone 23.

La figure 5 représente une seconde structure du transistor à effet de champ de puissance selon l'invention dans le cas où ce transistor comporte une tranchée sous la grille, plus connue sous le nom de "recess". Dans ce cas, la structure reste comparable à la structure représentée en figure 4, elle est seulement inversée puisque ce n'est plus la surface libre plane du transistor qui sert de niveau de référence pour les transitions progressives, mais la surface plane de la jonction entre le substrat semi-isolant et la couche active 12.

Pour obtenir une telle structure de transistor à effet de champ de puissance, le procédé consiste à implanter par faisceaux d'ions focalisés les éléments désirés, tels que du silicium ou du germanium par exemple, selon des bandes de résolution de 0,1 micron environ. En progressant depuis la grille vers le drain, ou depuis la grille vers la source, la dose d'implantation de la couche n+ est augmentée depuis $5 \times 10^{12}$ ions/cm$^2$ jusque $5 \times 10^{13}$ ions/cm$^2$, tandis que l'énergie diminue de 250 keV à 60 keV, dans le cas ou le dopant est du silicium, ce qui donne une transition douce entre couches n et n+. Un deuxième balayage par tranche à faible dose ($5 \times 10^{12}$) et forte énergie (250 à 350 keV) assure la réalisation de la couche n.

Les faisceaux d'ions focalisés sont générés par des machines qui disposent de source à métaux liquides. On entend par là des sources qui sont constituées par une pointe de tungstène par exemple mouillé par du gallium liquide. La couche de gallium liquide forme sous l'effet d'une tension d'accélération ce que l'on appelle un cône de Taylor : à l'extrémité de la pointe de tungstène, ce cône peut avoir un rayon de l'ordre de 30 angströms, et le champ y est de l'ordre de 1 volt par angströms. Il n'est pas possible avec des technologies mécaniques d'obtenir un cône ou une pointe d'une telle précision. Cette pointe émet donc un faisceau d'ions d'un diamètre qui est non pas limité aux environs de 30 angströms, mais qui est plutôt de l'ordre de 1000 angströms ce qui donne une précision supérieure à ce que l'on peut atteindre par d'autres techniques de bombardement ionique. L'utilisation d'alliage adapté permet l'obtention de faisceaux de divers types d'ions utilisés comme dopant dans la fabrication des circuits intégrés : le béryllium, le bore, le silicium, l'arsénic, le gallium, l'antimoine etc... sont utilisés comme charges d'implantation ionique.

La précision du faisceau d'ions focalisés, dans de telles machines, peut être pleinement utilisée car ces machines disposent d'un plateau dont le déplacement est controlé par interférométrie laser, ce qui permet donc d'opérer des balayages de la surface du transistor dans lequel on veut obtenir des transitions progressives avec une précision égale à 1000 angströms, qui est donc le diamètre du faisceau d'ions focalisés, dans un champ de balayage de l'ordre de 200 microns par 200 microns.

Par rapport à des transitors à effet de champ classiques, et ayant le même espacement entre grille et drain, les transistors selon l'invention, à transitions progressives, permettent une augmentation des tensions de claquage atteignant 50 %, une puissance de sortie plus élevée, et une amélioration du rendement électrique d'au moins 10 %.

Ils sont utilisés dans la fabrication de circuits intégrés de puissance, qui sont eux-mêmes destinés aux matériels de transmission de données de télécommunication, dans les radars ou matériels avioniques.

Bien entendu l'invention n'est pas limitée aux exemples représentés et décrits ci-dessus, et elle comporte toute modification évidente pour l'homme de l'art : le transistor et son procédé de réalisation sont précisés par les revendications suivantes.

## Revendications

1. Transistor hyperfréquence de puissance, comportant, supporté par un substrat (11), au moins une couche active (12), en matériau semiconducteur de type n, sous l'électrode de grille (13), et une couche en matériau dopé de type n+, formant deux régions (16, 17) de prises de contacts sous les électrodes de source et drain (14, 15), ce transistor étant caractérisé en ce que en vue d'éviter un champ électrique de forte densité aux jonctions entre la couche active (12), dopée n, et les régions (16, 17) de prises de contacts, dopées n+, le matériau de transition (18, 19) compris entre ladite couche active (12) et lesdites régions (16, 17) est dopé avec transition progressive du type n vers le type n+, la transition progressive étant orientée selon la direction de propagation des porteurs de charges électriques, depuis la grille vers la source (20 21) et depuis la grille vers le drain (22 23).

2. Transistor de puissance selon la revendication 1, caractérisé en ce que la transition progressive du niveau de dopage du matériau de transition (18, 19) est continue ou quasi-continue, par bandes de 1000 angströms de largeur.

3. Transistor de puissance selon la revendication 2, caractérisé en ce que la transition progressive du niveau de dopage du matériau de transition (18, 19) correspond à une transition de l'énergie (60 keV à 250 keV) et à une transition des doses ($5.10^{12}$ ions/cm$^2$ à $2.10^{13}$ ions/cm$^2$) de l'implantation à faisceaux d'ions focalisés qui crée la transition du niveau de dopage, depuis la proximité (20, 22) de la couche active (12), vers la proximité (21, 23) des régions (16, 17) de prises de contacts.

4. Transistor de puissance selon l'une quelconque des revendications 1 ou 2, caractérisé en ce qu'il est intégré dans un circuit intégré hyperfréquence de puissance.

0228956

# FIG_1

# FIG_2

# FIG_3

# FIG_4

FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 466 174 (TEXAS INSTRUMENTS) <br> * Colonne 3, lignes 29-38; figure 6 * | 1,2 | H 01 L 29/36 <br> H 01 L 29/80 |
| | --- | | |
| A | EP-A-0 005 461 (SIEMENS) <br> * Résumé; figure 2 * | 1 | |
| | --- | | |
| A | US-A-4 481 042 (T. TAKIGAWA et al.) <br> * Résumé * | 3 | |
| | --- | | |
| A | EP-A-0 070 810 (M. BUIATTI) | | |
| | --- | | DOMAINES TECHNIQUES RECHERCHES (Int. Cl.4) |
| A | PATENTS ABSTRACTS OF JAPAN, vol. 7, no. 140 (E-182)[1285], 18 juin 1983; & JP-A-58 52881 (OKI DENKI KOGYO K.K.) 29-03-1983 | | H 01 L |
| | ----- | | |

Le présent rapport de recherche a été établi pour toutes les revendications

| Lieu de la recherche | Date d'achèvement de la recherche | Examinateur |
|---|---|---|
| LA HAYE | 20-03-1987 | PELSERS L. |